# EUROPEAN PATENT APPLICATION

(11) **EP 1 002 740 A1**
(43) Date of publication of application: **24.05.2000**
(21) Application number: 98122001.5
(22) Date of filing: 19.11.1998
(51) Int. Cl.: B65D 73/02, B65B 15/04, H05K 13/00

(54) **Carrier band of electronic parts**

(71) Applicant: Nissho Corporation, Osaka-shi, Osaka 530-0047 (JP)
(72) Inventor: Mori,Kazuhiro, Osaka 591-8011 (JP); Itemadani, Eiji, Osaka 591-8011 (JP); Tanaka, Souhei, Osaka 572-0029 (JP); Hikita,Osamu, Osaka 573-0001 (JP); Tomii, Uzo, Nara 636-0133 (JP); Sugio, Kanji, Kyoto-shi 601-8452 (JP); Shoji,Teruo, Osaka-567-0048 (JP); Asao,Yukihiko, Aichi 487-0011 (JP)
(74) Representative: Glawe, Delfs, Moll & Partner

(57) **Abstract**

An object of the present invention is to provide a carrier band of electronic parts which can carry electronic parts such as an IC package in good protected condition without spoiling convenience of the carrier tape using the convexities and the sticking tape.

The invention provides an electronic parts carrier band T which includes a flexible band 10 and keeps and carries longitudinally at intervals a large quantity of electronic parts 40 having a part body 42 and projecting portions 44, with the carrier band comprising: supporting stands 20, which are mounted longitudinally at intervals and projected on the band 10; supporting faces 22, which are formed on the supporting stands 20 and support the electronic parts 40 by contacting the part body 42; opening portions 26, which are opened from the supporting faces 22 to a part of both side faces 24 of the supporting stands 20 at positions corresponding to the part bodies 42; and a sticking tape 30, which is longitudinally affixed to a back side of the band 10 including the supporting faces 22 by a one-sided sticking face 32 of the sticking tape 30, wherein a part of the sticking face 32 is exposed to a position, being stuck to the part bodies 42, of the opening portions 26.

## Description

### TECHNICAL FIELD

The present invention relates to a carrier band of electronic parts, and more particularly, to a carrier band which is used to carry small electronic parts such as an IC package for transportation and deposit and so on and keeps many electronic parts together.

### BACKGROUND ART

An IC package comprises a block-type body including a synthetic resin or a ceramics in which an IC chip is enclosed and terminal pieces (leads) as many legs projecting toward the surroundings of the body. Especially, in the IC package of the structure called "flat package", there are occasions that many terminal pieces in lines horizontally project from at least two sides of the body and the terminal pieces bend and their pointed ends are positioned below the bottom of the body.

A carrier tape is given as a carrier means which can transport and deposit efficiently a large quantity of the IC packages and can easily treat the IC packages. The carrier tape comprises a tape including a synthetic resin which has sprocket holes in parallel in side edges as a movie film. The IC packages are laid in storing dents emboss-formed to this carrier tape and the storing dents are covered by a covering film.

However, in the method of storing the IC packages in the storing dents of the carrier tape, there was a defect that the IC packages or the terminal pieces collide against the inner side of the storing dents and the terminal pieces are apt to bend.

The technique to solve such a problem is disclosed in JP-A-06-219412. In this technique, convexities are formed on the carrier tape and a piercing hole is formed in the center of the convexity and a sticking face of the sticking tape affixed to the carrier tape from the back side of the convexities is exposed from the piercing holes and the IC packages mounted on the convexities are stuck and fixed on the sticking face. By mounting the IC packages on the convexities, it is prevented that the terminal pieces of the IC packages touch the carrier tape and are damaged.

However, in the above carrier tape having the convexities and the sticking tape, there is a problem that keeping and fixing of the IC packages are apt to be insufficient.

As the convexities are formed inside the width of the carrier tape, the width of the convexities is fairly narrower than the width of the carrier tape. By the restriction of forming, the upper face of the convexities is narrower than the lower face. The piercing hole opened on the upper face of the convexities becomes further narrower. Therefore, the sticking face which is exposed from the piercing hole and stick and fix the IC packages becomes narrower and keeping and fixing of the IC packages become insufficient.

Also, a part of the sticking tape must be formed as project from the back side of the piercing hole to the same height position as the upper face of the convexities of the surface to contact the sticking face to the lower face of the IC packages. For that, it is necessary to bend the sticking tape from the back side to the face side at the inner edge of the piercing hole. As for the sticking tape made of paper and so on, though it is comparatively easy to bend longitudinally in one direction, that is to say, two-dimensionally, it is difficult to bend three-dimensionally in both directions of length and width. Therefore, it is necessary to make the width of the sticking tape narrower than the width of the piercing hole and to make the condition of bending the sticking tape only in a direction of length in order to make the bending of above-mentioned sticking tape easy. As a result, the width of the sticking face becomes further narrower than the width of the piercing hole.

Furthermore, as an another problem, there is a problem that the sticking tape affixed to the back of the carrier tape is apt to meander.

At the back of the carrier tape, the sticking tape is arranged along an uneven shape resulted at the back of the convexities and is thrusted out from the back to the surface of the piercing hole. Therefore, the sticking tape can not be stuck exactly as being stuck to an even face and is apt to meander. When the sticking tape meanders and is not arranged exactly in the center of the width of the piercing hole, the sticking face exposed from the piercing hole becomes small and the side edge of the sticking tape is caught by the inner edge of the piercing hole and the sticking tape can not be thrust up to the face side of the piercing hole. As a result, the IC packages can not be sufficiently stuck and fixed.

Now, except the IC package, there are many electronic parts having structure portions which are weak and apt to be damaged, such as a microscopic portion projecting from the part body. Such electronic parts have the above-mentioned problems.

### DISCLOSURE OF THE INVENTION

### OBJECTS OF THE INVENTION

An object of the present invention is to provide a carrier band of electronic parts which can carry electronic parts such as an IC package in good protected condition without spoiling the convenience of the above-mentioned carrier tape using the convexities and the sticking tape.

### SUMMARY OF THE INVENTION

To solve the above problems, the invention according to Claim 1 is a carrier band of electronic parts which includes a flexible band and keeps and carries longitudinally at intervals a large quantity of electronic parts having a part body and projecting portions projected from the part body,
with the carrier band comprising:
supporting stands, which are mounted longitudinally at intervals and projected on the band;
supporting faces, which are formed on the supporting stands and support the electronic parts by contacting the part body;
opening portions, which are opened from the supporting faces of the supporting stands to a part of both side faces of the supporting stands as a width direction of the band; and
a sticking tape, which is longitudinally affixed to a back side of the band including the supporting faces by a one-sided sticking face of the sticking tape, wherein a part of the sticking face is exposed to a position, being stuck to the part bodies, of the opening portions.

These and other objects and the advantages of the present invention will be more fully apparent from the following detailed disclosure.

### DETAILED DESCRIPTION OF THE INVENTION

Respective composing elements are concretely explained.

### [Electronic Parts]

As for electronic parts, among semiconductor apparatuses such as IC packages of various structures called QPF, J-lead article, TSOP and so on, sensor apparatus and other electronic parts, the present invention is applied to electronic parts which have around the part body projecting portions as easily damaged projecting structures such as terminal pieces. The projecting portions are made of material such as metal, synthetic resin, glass and ceramics and have weak figure or structure which are easily damaged by impact or by friction contact. And, their arrangement and figure are not restricted. In many cases, the projecting portions thrust from the side of the part body toward the outside. However, there are cases that the projecting portions thrust from the upper face of the part body or that the projecting portions thrust from a part of the lower face of the part body. The material and the figure of the part body are not especially restricted. However, the part body preferably has such an outside figure as can be supported steadily by the below-mentioned supporting face as a rectangular parallelepiped.

### [Band]

Material of the band is used the same as a tape material which is used in the conventional carrier tape as far as the material has enough flexibility to be able to be treated at the time of carrying. The material is preferably fit for the formation of the supporting stands and the processing of the opening portions. Concretely speaking, a film material or a sheet material made of synthetic resin, ceramics or paper and so on is used in one or many layers. It is preferable to use the material which is easy for the abandoning treatment such as a destruction by fire.

The width of the band is established a little larger than the external form of the carried electronic parts. To use the band in common for at least two kinds of electronic parts, the width should be established according to the electronic parts of the maximum size. In some of the existing carrier tape treating apparatuses, the width of the carrier tape is standardized. Therefore, by adapting the width of the carrier tape to such standards, the carrier tape becomes usable in the existing carrier tape treating apparatuses.

In the band, can be formed carrying means such as sprocket holes which are used to travel the carrier band mechanically. As the carrying means, employed are mechanical structures travelling usual band-type material, such as holes, slits, notches and projections. The carrying means are usually formed in the both side edge of the band where keeping of the electronic parts is not disturbed. However, the carrying means may be formed in one-side edge of the band. The carrying means may be formed in the center of the band, if keeping of the electronic parts is not disturbed.

### [Supporting Stands]

The supporting stands are mounted longitudinally at intervals on the band. The intervals are preferably to the extent as the electronic parts are not mutually interfered when the electronic parts are kept on respective supporting stands.

As for the figure of the supporting stands, the supporting stands preferably have figures and measurements as the supporting stands can support stably the electronic parts. The figure of the supporting stands may be different from the plane figure of the electronic parts and the area of the supporting stands may be narrower than the area of the electronic parts. A part of the supporting stands may be arranged outside the external form of the part body of the electronic parts. In this case, the supporting stands should be arranged so that the projecting portions of the electronic parts do not touch the supporting stands. As the concrete figures of the supporting stands, pyramids of which plane is a polygon such as a rectangle, a circle or an ellipse, can be employed.

The height of the supporting stands is established to the extent as the projecting portions of the kept electronic parts do not touch the surface of the band around the supporting stands and become rising condition. However, if the supporting stands are too high, the keeping of the electronic parts becomes unstable and the bulk becomes high and the manufacturing labor increases. Concretely speaking, the height of the supporting stands should be established from 0.5 mm to several mm.

Usually, one supporting stand is arranged to one electronic part. However, one electronic part can be supported by at least two electronic parts.

In order to correspond one supporting stand to at least two kinds of electronic parts of which measurements and figures are different, the figure of the supporting stand should be established so that the projecting portions of the electronic parts do not touch the supporting stand or the surface of the band if any electronic parts of the minimum measurement or the maximum measurement are kept.

### [Supporting Face]

Usually, the supporting face is the highest edge face of the supporting stand. Upper face portions except the highest edge face of the supporting stand can be made as the supporting face. The figure and the extent of the supporting faces are established as the supporting faces contact the bottoms of the electronic parts and can support stably the electronic parts. The figures of the supporting stands may be similar to the figures of the bottoms of the electronic parts. As the figures of the supporting stands, figures such as a rectangle and a circle can be employed.

### [Opening Portions]

The opening portions are formed piercing the band. A part of the opening portions is arranged on the supporting face and at least a division of the part of the opening portions is arranged at positions corresponding to the part bodies of the electronic parts. A part of the opening portions may be arranged on the supporting stands except the supporting faces or on the surface of the band. A part of the opening portions may be arranged at positions separated from the external form of the part bodies.

Size of the opening portions is established to the extent as the sticking tape which has sufficient area to keep and fix the electronic parts, is arranged to be exposed from the opening portions. If the width of the opening portions in the width direction of the band is established as wider the width of the sticking tape, when the sticking tape is pushed up from the back side of the opening portions and bent and the sticking faces are arranged at the same height position of the supporting faces in the opening portions, the both side edges of the sticking tape are not caught by the side edge of the sticking tape and the arrangement of the sticking face is not disturbed.

In case the opening portions are arranged from the supporting faces of the supporting stands to a part of the both sides of the supporting stands in the width direction of the band, even if the width of the sticking tape is as wide as the total width of the supporting faces, it can be prevented that the both side edges of the sticking tape are caught by the side edge of the opening portions. Conversely speaking, even in case of the supporting stands or the band of comparatively narrow width, the enough wide opening portions which are not caught by the both side edges of the sticking tape, can be constituted and the sticking faces of wide area can be exposed to the opening portions.

In case the opening portions are arranged to the both side faces of the supporting stands, the figure or the size of the opening portions are not especially limited as far as the arrangement of the above-mentioned sticking tape is not prevented.

When the opening portions are arranged on the supporting faces, the substantial area of the supporting faces decreases. Therefore, it is preferable that the size of the opening portions is established so that the sufficient area of the supporting faces for supporting the electronic parts, is maintained.

At least two opening portions can be arranged on one supporting stand or on one supporting face. By keeping one electronic part on the sticking faces exposed from the at least two opening portions, the electronic part is kept stably. Also, if one large opening portion is formed, the strength of the supporting stand is apt to become weak and supporting of the sticking tape arranged in the opening portion is apt to become unstable. However, by dividing the same area into at least two opening portions, the strength of the supporting stand is sufficiently maintained and the sticking tape is steadily supported.

### [Sticking Tape]

The sticking tape affixes and fixes the part body by being arranged to expose to positions wherein a part of the one-sided sticking face is stuck to the part bodies of the electronic parts, of the opening portions. Accordingly, it is preferable that the sticking faces of the sticking tape is arranged at the sticking position to the part bodies, that is to say, the same height position as the upper face of the supporting faces.

As for material of the sticking tape, the usual tape materials such as paper, synthetic resin or a metal leaf, are used. The soft material which can be steadily stuck along the uneven figure of the supporting stands to the back of the band, is preferable.

As for the adhesive constituting the sticking faces, the usual adhesives employed generally to stick and fix various articles, are used. The various adhesives prepared according to the sticking characteristic with the electronic parts, can be used. For example, when the part bodies of the electronic parts are made of silicon resin, silicon-based adhesives are preferable. Preferably, the sticking force of the sticking face is to the extent that the sticking tape can be affixed to the band and that the electronic parts can be kept temporarily and the electronic parts neither soiled nor receive a bad influence at the time of peeling off.

As for the width of the sticking tape, necessary is the width to the extent that the electronic parts can be stuck and kept steadily by the section exposed to the opening portions. When the width of the sticking tape is a little narrower than the width of the opening portions, easy is the operation of bending the sticking tape and arranging the sticking face at the same height position as the supporting face. If the width of the sticking tape is as wide as the inner width of the back side of the supporting face, the side portion of the supporting stands arranged at the both sides of above-mentioned inner width operates as a guide which prevents meandering of the sticking tape at the time of affixing the sticking tape.

### [Protecting Convexities]

The protecting convexities are arranged at need around the supporting stands on the surface of the band. The protecting convexities are made of the same material as the band such as synthetic resin and paper. The protecting convexities can be emboss-formed at the same time with forming of the supporting stands on the band. The protecting convexities manufactured by different material from the band, may be joined to the band.

As the protecting convexities, pillar shape such as a column, a prism and a pyramid, wall shape which form a straight line or a curve and uneven figure along the external form of the electronic parts, are employed.

The achievable function of the protecting convexities is different according to their arrangement and figure.

For example, the protecting convexities which are arranged at positions of the same height as the supporting stands and corresponding to the part bodies of the electronic parts, can keep stably the electronic parts by cooperating with the supporting stands. The linear protecting convexities can protect the electronic parts consequently by raising transformation-proof or hardness of the band to the direction of bending the protecting convexities. The protecting convexities which are arranged higher than the electronic parts kept by the supporting stands, can protect the electronic parts as barriers surrounding the electronic parts. There are occasions that the protecting convexities of one kind operate at least two functions of the above-mentioned function.

### BRIEF DESCRIPTION OF THE DRAWINGS

Fig. 1 is a top view of an embodiment according to the present invention.
Fig. 2 is a partial sectional side view of Fig. 1.
Fig. 3 is a sectional view of a perpendicular direction of Fig. 2.
Fig. 4 is a partial sectional side view showing used condition.
Fig. 5 is a sectional view of a second embodiment.
Fig. 6 is a perspective view of a third embodiment.
Fig. 7 is a top view of Fig. 6.
Fig. 8 is a sectional view of a fourth embodiment.
Fig. 9 is a perspective view of a fifth embodiment.
Fig. 10 is a sectional view of sixth embodiment.
Fig. 11 is a top view of Fig. 10.

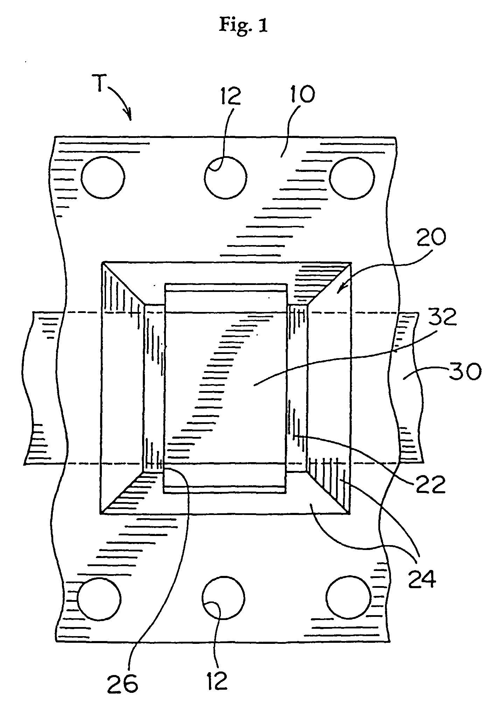

In Figs 1-11, 10---band, 12---sprocket hole, 20---supporting stand, 22---supporting face, 24---side face, 26---opening portion, 30---sticking tape, 32---sticking face, 40---IC package, 42---part body, 44---terminal piece, 62∼68---protecting convexity.

### BEST MODE FOR CARRYING OUT THE INVENTION

### -First Embodiment-

The first embodiment shown in Figs. 1-4 is a carrier band used to carry QFP-type IC packages.

### [Structure of Carrier Band]

As shown in Figs. 1-3, the cater band T includes a band 10 made of synthetic resin and a sticking tape 30 affixed to the back of the band 10. In the sticking tape 30, a silicon-based adhesive is applied to one side of a thin paper.

Supporting stands 20 formed as square pyramids are mounted longitudinally at regular intervals on the surface of the band 10. The supporting stands 20 are projections of the band 10 preferably made by emboss-forming the band 10. Each supporting stand 20 has an upper supporting face 22, which may be square or rectangular, and four inclined side faces 24 arranged around the supporting face 22 and connecting it to the undeformed main portion of the band 10.

Each supporting stand 20 has a cut-out or opening portion 26 of generally rectangular shape extending in the width direction of the band 10. The opening portion 26 extends over the width of the supporting face 22 and approximately to the middle of each side face 24 which extends parallel to the longitundinal direction of the band 10. As a result, the supporting face 22 is divided into two strips extending in the width direction of the band and being separated in the length direction of the band by the opening portion 26.

Many circular sprocket holes 12 penetrating the band 10 are arranged at regular intervals on the both side edges of the band and are used to travel successively the carrier band T.

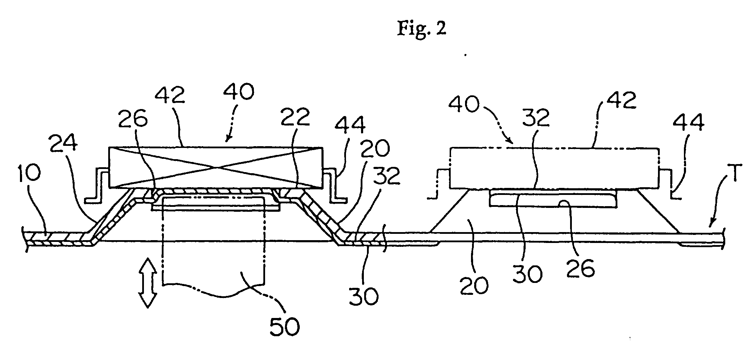

The sticking tape 30 is affixed to the back of the band 10 along a center line. The sticking tape 30 has a sticking face 32 applied the adhesive on the contacting side with the band 10. The sticking tape 30 is affixed along the uneven figure of the back of the supporting stands 20. The sticking face 32 of the sticking tape 30 is exposed to the opening portions 26 and is arrange at the nearly same height position as the supporting faces 22. Therefore, as shown in Fig. 2, the sticking tape 30 is bent perpendicularly at the back side of the supporting stands 20 from the back of the supporting faces 22 along the inner edges of the opening portions 26 and, furthermore, the sticking tape 30 is bent horizontally from the inner upper edges of the opening portions 26 and the sticking face is arranged at the same face with the upper face of the supporting faces 22.

The width of the sticking tape 30 is established nearly as wide as or a little narrower than the width of the supporting faces 22. Therefore, the sticking face 32 is exposed at the opening portions 26 extending nearly all the width of the supporting faces 22. The sticking tape 30 and the sticking face 32 are not arranged at positions corresponding to the side faces 24, 24, of the opening portions 26 and there are slits.

### [Mounting Operation of IC Packages]

As shown in Fig. 2, while the carrier band T including the band 10 and the sticking tape 30 is traveled to the fixed direction by a carrying apparatus of which illustration is omitted, IC packages 40 provided from a different carrying apparatus are mounted on the upper side of the supporting stands 20.

The IC package 40 has a flat rectangular parallelepiped shape and includes a part body 42 in which an IC chip is enclosed and terminal pieces 44 as many projections arranged projecting horizontally from the four side faces of the part body 42. The terminal pieces project horizontally from the part body 42 and their tips bend downward and their pointed ends bend again horizontally. The pointed ends of the terminal pieces 44 are positioned below the bottom of the part body 42.

The center of the bottom of the IC packages 40 is arranged to contact the supporting faces 22 of the supporting stands 10. As a result, the bottom of the IC packages 40 is contacted and stuck to the sticking face 32 of the sticking tape 30 which is exposed to the opening portions 26.

At this time, the IC packages 40 can be stuck to the sticking face 32 steadily and strongly by pushing the IC packages 40 to the sticking face 32 with a back-pushing stuff 50 such as gum which has a elasticity. Still, the back-pushing stuff 50 is advanced to the inner upper portion of the supporting stands 20 only while the IC packages 40 are stuck to the sticking face 32, and the back-pushing stuff 50 is left to the lower portion of the traveling carrier tape T when the sticking operation is finished.

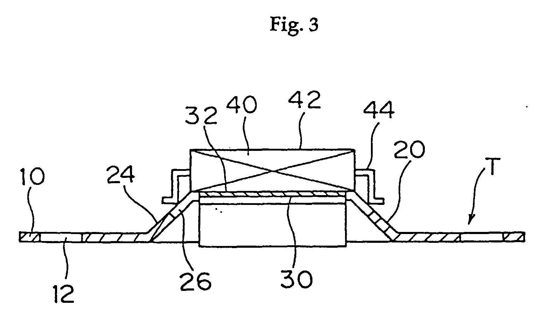

In the IC packages 40 arranged on the supporting stands 20, as the length of the IC packages is established longer than the length of the supporting faces 22 of the supporting stands 20 in the length direction of the band 10, the terminal pieces 44 projecting toward surroundings are in the condition of flowing the higher space than the surface of the band 10 at the side faces 24 of the supporting stands 20. As shown in Fig. 3, as the width of the IC packages 40 is as wide as the width of the supporting faces 22 in the width direction of the band 10, the terminal pieces 44 are arranged at positions of the side faces 24 of the supporting stands 20. However as the opening portions 26 are arranged at the side faces 24 in this portion, the terminal pieces 44 are arranged in the space of the opening portions 26 and do not touch the band 10.

In this way, the carrier band T keeping the IC packages is used for transportation and deposit and so on in the remaining condition of a long film, in the condition of being cut off at regular lengths and bent or in the condition of being rolled up in a vortex. The band 10 is not much transformed in the section wherein the supporting stands 20 are formed. However, the band 10 can be transformed to some extent as a usual carrier tape and so on in the section between the fellow supporting stands 20. Therefore, above-mentioned rolling up in a vortex can be done easily. If the carrier band T overlaps each other, the bottom of the band 10 touches only the upper face of the IC packages 40 and the terminal pieces 44 do not touch directly the overlapped band 10.

As is shown from the above explanation, in the carrier band T of the above embodiment, as far as the part bodies 42 can be mounted on the supporting stands 20 in the condition of flowing the terminal pieces 44 of the IC packages 44, figure and measurement of the IC packages 44 are not especially limited. Accordingly, one kind of the carrier band T can be used combinationally to carry at least two kinds of the IC packages 40 or other electronic parts.

### [Taking Out Operation of IC Packages]

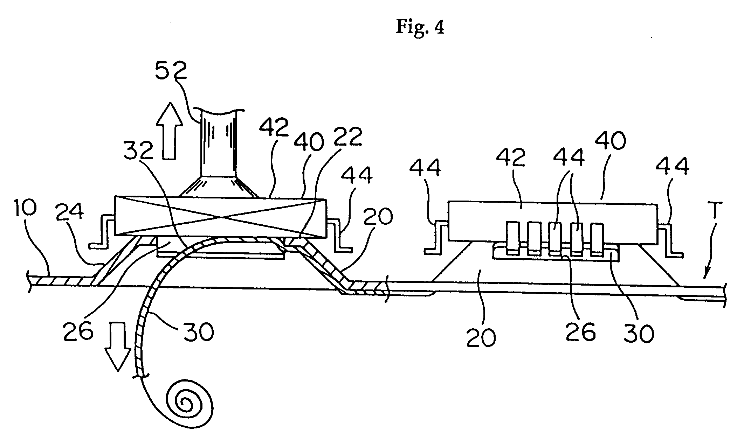

As shown in Fig. 4, the carrier band T is traveled to the fixed direction in the same manner with the mounting operation and the sticking tape 30 is rolled up from one end and is peeled off from the back of the band 10. At the same time, a vacuum absorbing pad 52 is put to the upper face of the IC packages 40 and the IC packages 40 are absorbed and raised upward. As a result, the IC packages 40 are certainly peeled off from the sticking face 32 and taken out from the carrier band T.

At this time, the IC packages 40 can be peeled off from the sticking tape 30 and taken out only by absorbing the IC packages 40 with the vacuum absorbing pad without peeling off the sticking tape 30 from the band 10. Also, it is possible to take out the IC packages 40 by thrusting up a needle-shaped stuff from the back side of the sticking tape 30 and thrusting out the IC packages 40 with the needle-shaped stuff penetrating the sticking tape 30. However, in the case of the IC packages 40 which are thin and structurally weak, above method of peeling off the sticking tape 30 from the band is preferable because a burden applied to the IC packages is decreased. Still, the terminal pieces 44 of the IC packages do not touch other things at the time of taking out.

The band 10 after being taken out the IC packages 40 and being peeled off the sticking tape 30, can be used again as the carrier band T by affixing the sticking tape again. If the sticking tape 30 is not peeled off from the band 10 and remains affixed, the carrier band T including the sticking tape 30 as well as the band 10 can be used again. However, in this case, it should be managed that the sticking force of the sticking face 32 does not lower.

### -Second Embodiment-

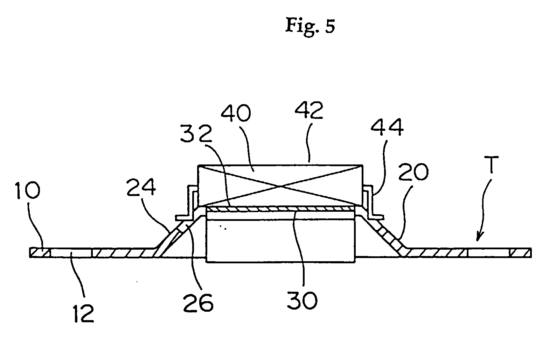

In the second embodiment shown in Fig. 5, the carrier band T which is fundamentally in common with the above-mentioned first embodiment, is used.

However, the terminal pieces 44 of the IC packages 40 project downward at positions which are close to the part body 42. In the IC packages like this, if the terminal pieces 44 are arranged in space by the section of the opening portions 26 which is arranged at the side faces 24 of the supporting stands 20, it is prevented that the terminal pieces 44 touch the cater band T and are damaged.

In the embodiment like this, it is preferable that the opening portions 26 are formed extending to a comparatively wide range of the side faces 24.

### -Third Embodiment-

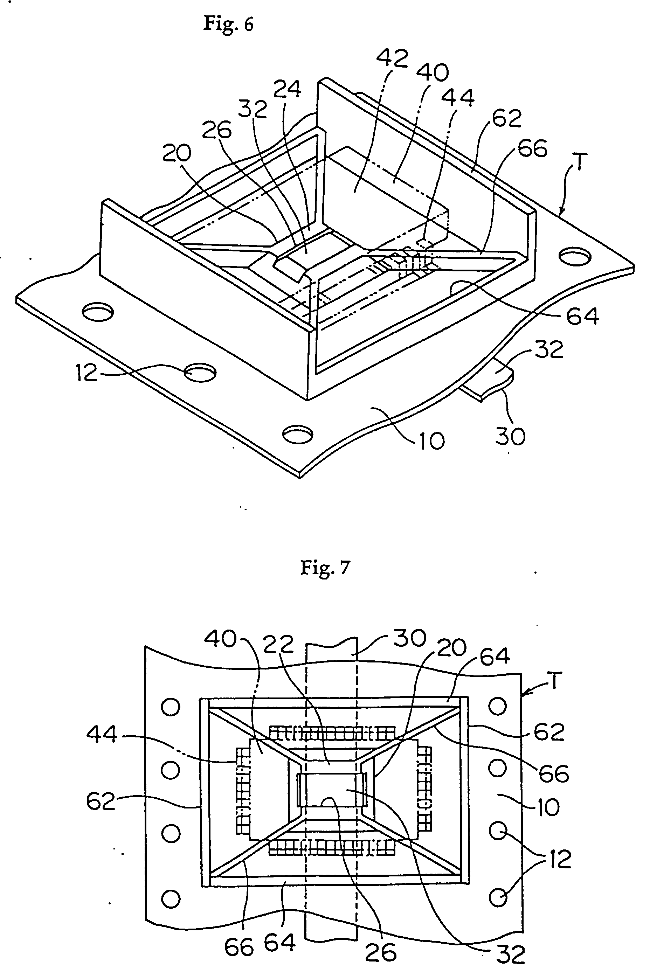

In the third embodiment shown in Fig. 6 and Fig. 7, protecting convexities are formed.

The structure of the band 10, supporting stands 20 and the sticking tape 30 is in common with the above-mentioned embodiment.

As shown in Fig. 7, frame-shaped protecting convexities 62, 64 are arranged in plain and rectangular figure surrounding the outside of the IC packages 40 kept by the supporting stands 20, and diagonal-shaped protecting convexities 66 which link four corners of the frame-shaped protecting convexities 62, 64 and four corners of the supporting stands 20, are arranged.

As shown in Fig. 6, the diagonal-shaped protecting convexities 66 is established at the same height as the supporting stands 20 and their upper faces at the same height as the supporting faces 22 of the supporting stands 20, extend radiately. Among frame-shaped protecting convexities 62, 64, a pair of the protecting convexities 64, 64 arranged in the length direction of the band 10 is established at the same height as the supporting faces 20 or the diagonal-shaped protecting convexities 66. A pair of the protecting convexities arranged in the width direction of the band 10 is established at the further higher position than the upper edges of the IC packages 40 kept by the supporting stands 20.

These protecting convexities 62-66 are manufactured by emboss-forming the band 10 as the supporting stands 20.

When the IC packages 40 are mounted on the cater band T which has above-mentioned structure, the bottoms of the part bodies 42 of the IC packages 40 are supported by the supporting stands 20 and a part of the diagonal-shaped protecting convexities 66. This enable a stabler keeping than a keeping only by the supporting stands 20. As shown in Fig. 7, as the diagonal-shaped protecting convexities 66 are arranged diagonally without touching the terminal pieces 44 of the IC packages 44, there is no occasion that the terminal pieces 44 are touched and damaged.

As the diagonal-shaped protecting convexities 66 and the frame-shaped protecting convexities 62, 64 raise transformation-proof and hardness the whole band 10, it can be prevented that the band 10 is transformed and touches the terminal pieces 44.

By the higher protecting convexities 62 than the IC packages 40, touching of other objects to the IC packages can be prevented. When the cater bands T are overlapped, it can be prevented by the protecting convexities 62 that another carrier band T touches on the IC packages 40 and a burden is applied.

In the embodiment shown in figures, three kinds of the protecting convexities composed of the diagonal-shaped protecting convexities 66 and high and low two kinds of the frame-shaped protecting convexities 62, 64, are combined. However, if only one kind or two kinds of the protecting convexities are formed, function of each protecting convexity can be operated.

### -Fourth Embodiment-

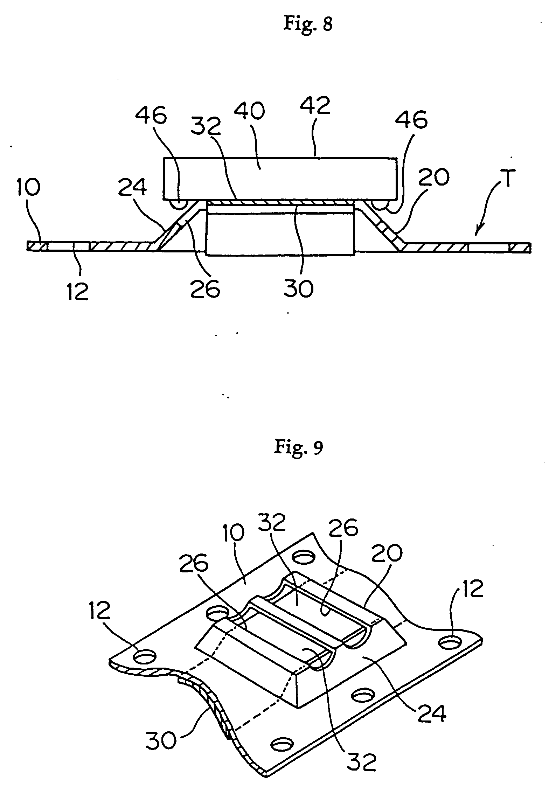

The fourth embodiment shown in Fig. 8 is a case when the ball-grid-type IC packages 40 are carried.

Hemisphere-shaped connecting terminals 46 are arranged along surroundings on the lower faces of the IC packages 40. Even in the case of the IC packages 40 like this which have protruding structure on the lower faces, if the IC package 40 has a flat plane in the center of the lower face wherein the sticking tape 30 can be stuck and the supporting stand 20 can stably support, the IC packages 40 can be kept smoothly.

### -Fifth Embodiment-

In the fifth embodiment shown in Fig. 9, the opening portions 26 are arranged at the at least two positions of the supporting face 22. The opening portions 26 are in a row along the length direction of the band 10. The portions arranged at the side faces of the supporting stand 20 have arc side edge shape, of the opening portions 26.

In the above-mentioned embodiment, the opening parts of the supporting face 22 are small in comparison with the case wherein the large opening portions totaled with the before and behind opening portions 26 are formed. Furthermore, as the structure corresponding to a reinforcing beam is arranged between the before and behind opening portions 26, 26, the strength of the supporting stand 20 is raised. As the sticking tape 30 is affixed to the back of the supporting stands 22 in the middle section of the before and behind opening portions 26, 26, the sticking tape 30 is steadily supported.

### -Sixth Embodiment-

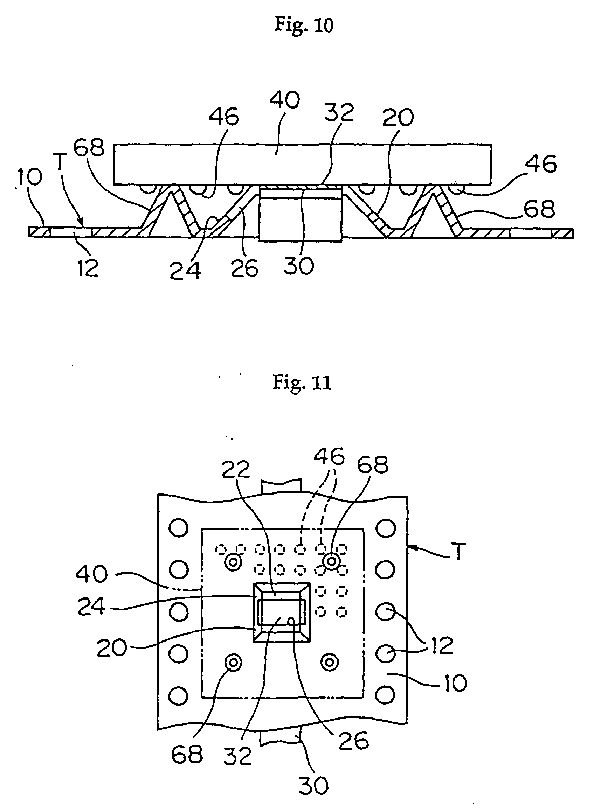

The sixth embodiment shown in Figs. 10 and 11 is applied as the above-mentioned embodiment shown in Fig. 9 to the ball-grid-type IC packages 40 which have protruding structure on the lower faces. As the fundamental structure is in common with the above-mentioned embodiment shown in Fig. 9, different points are mainly stated.

The IC packages 40 have many connecting terminals 46 from the inside to the surroundings of the lower faces. Therefore, if only the center section wherein the connecting terminals 46 are not arranged, is supported by the supporting stands 20, supporting of surrounding section becomes unstable.

Then, cone-shaped protecting convexities 68 of which upper edges are flat, are arranged in the area outside of the supporting stands 20 wherein the connecting terminals 46 are not arranged, of the lower faces of the IC packages 40. The height of the protecting convexities is established nearly the same as the height of the supporting stands 20 or the height of the sticking face 32.

As shown in Fig. 11, the protecting convexities 68 are arranged diagonally at four positions of the supporting stand 20 or the IC package 40. The protecting convexities 68 are manufactured by emboss-forming at the same time with forming of the supporting stands 20.

The IC packages 40 do not touch the connecting terminals 46 and their whole lower faces can be stably supported by the supporting stands 20 in the center and the protecting convexities 68 arranged around the supporting stands 20.

The cone-shaped protecting convexities 68 of the above-mentioned embodiment can be used instead of the diagonal-shaped protecting convexities 66 in the embodiment of Figs. 6 and 7.

### -Other Embodiment-

Figure and measurement of the section arranged on the side faces 24 of the supporting stands 20, of the opening portions 26, are not restricted to the above-mentioned embodiments and can be modified variously.

For example, in above-mentioned embodiment of Fig. 1, opening portions 26 of which plane is rectangular, is employed. However, the before and behind edges of the opening portions 26 may be inclined at the section of the side faces 24 and the width of the before and behind edges of the opening portions 26 may be narrow.

If the ratio occupied by the opening portions 26 at the height direction of the side faces 24 is increased, the terminal pieces 44 can be stored as above-mentioned embodiment of Fig. 5. However, the opening portions 26 may be arranged only close to the upper edges of the side faces 24 as far as the terminal pieces 44 are not caught by the sticking tape 30 arranged nearly on the whole of the supporting faces 22.

### INDUSTRIAL APPLICATION

According to the carrier band of electronic parts of the present invention, the opening portions of the supporting stands are opened from the supporting faces of the supporting stands to a part of the both side faces of the supporting stands as width direction of the band. Therefore, if the wide sticking tape extending to the whole width of the supporting faces is used, the side edge of the sticking tape is hard to be caught by the inner side edge of the opening portions and the operation of pushing up the sticking tape exposed to the opening portions to the same face as the supporting face and arranging the sticking tape, is easy. As a result, the electronic parts can be kept satisfactorily by sticking steadily the sticking face of wide area to the electronic parts and the miniaturization of the carrier band and the reduction of the material cost can be achieved and the keeping function of the electronic parts is improved.

## Claims

1. A carrier band carrying a plurality of electronic parts which are arranged at space to longitudinal intervals along a flexible band, the carrier band comprising:
supporting stands (20) formed as projections of the band (10) and arranged at spaced intervals longitudinally of the band;
the supporting stands (20) having supporting faces (22) which support the electronic parts, and side faces (24) connecting the supporting faces (22) to the main portion of the band (10);
openings (26) formed in the supporting faces (22) of the supporting stands (20) and generally extending in width direction of the band into the side faces (24); and
an adhesive tape (30) longitudinally affixed to the backside of the band (10) including the supporting faces (22), whereby a part of the adhesive tape (30) is exposed in said openings (26) and affixed to the electronic part supported by the support surface (20).

2. A carrier band as claimed in claim 1, further comprising protecting convexities (62, 64, 66) which project from the surface of the band (10) at least partly around each supporting stand (20) to protect the electronic parts supported by the supporting stand (20).

3. A carrier band as claimed in claim 1 or 2, wherein two or more openings (26) are formed in each supporting face (22).
